## Europäisches Patentamt
## European Patent Office
## Office européen des brevets

(11) Publication number: **0 121 997**
**B1**

(12)

# EUROPEAN PATENT SPECIFICATION

(45) Date of publication of patent specification: **02.11.88**

(51) Int. Cl.⁴: **H 01 L 21/28, H 01 L 29/80**

(21) Application number: **84301215.4**

(22) Date of filing: **24.02.84**

(54) Schottky gate field effect transistor and method for producing it.

(30) Priority: **04.03.83 JP 36496/83**

(43) Date of publication of application:
**17.10.84 Bulletin 84/42**

(45) Publication of the grant of the patent:
**02.11.88 Bulletin 88/44**

(84) Designated Contracting States:
**DE FR GB NL SE**

(56) References cited:
**EP-A-0 057 605**

**IEEE TRANSACTIONS ON ELECTRON DEVICES, vol. ED-29, no. 11, November 1982, pages 1772-1777, New York, USA; K. YAMASAKI et al.: "GaAs LSI-directed MESFET's with self-aligned implantation for n+-layer technology (SAINT)"**

**JAPANESE JOURNAL OF APPLIED PHYSICS-SUPPLEMENTS, vol. 22, suppl. no. 22-1, 1982, pages 381-384, Tokyo, JP; K. YAMASAKI et al.: "N+ self-aligned MESFET for GaAs LSIs"**

**IEEE ELECTRON DEVICE LETTERS, vol. EDL-1, no. 12, December 1980, pages 259-262, New York, USA; G.V. RAM et al.: "On the scaling of Si-MESFETs"**

(73) Proprietor: **SUMITOMO ELECTRIC INDUSTRIES LIMITED**
No. 15, Kitahama 5-chome Higashi-ku
Osaka-shi Osaka 541 (JP)

(72) Inventor: **Suzuki, Tomihiro Osaka Works Sumitomo Electric Ind. Ltd. 1-3, Shimaya 1-chome**
Konohana-ku Osaka (JP)
Inventor: **Kikuchi, Kenichi Osaka Works Sumitomo Electric Ind. Ltd. 1-3, Shimaya 1-chome**
Konohana-ku Osaka (JP)

(74) Representative: **Rackham, Stephen Neil et al GILL JENNINGS & EVERY 53-64 Chancery Lane London WC2A 1HN (GB)**

(56) References cited:
**ELECTRONIC LETTERS, vol. 17, no. 22, October 1981, pages 834-836, London, GB; Y. ISHII et al.: "Self-aligned normally-off GaAs MESFET using SN-doped SiO2 glass"**

Courier Press, Leamington Spa, England.

EP 0 121 997 B1

# Description

A Schottky gate field effect transistor (hereinafter called MESFET) is widely used as an amplifier or oscillator device particularly in the ultra-high-frequency band. Further, it is known that MESFET's are ideal basic components of integrated circuits for ultra-high-speed operation.

A Schottky gate field effect transistor comprises a semi-insulating semiconductor substrate, an active layer formed on the semiconductor substrate, and a source electrode, a Schottky gate electrode, and a drain electrode all formed on the active layer. Such conventional MESFET's have the disadvantage that a sufficiently large transconductance gm is not obtained because of the large resistance existing between the gate and source or gate and drain. The noise characteristic of such a device is also lowered by the large series resistance that exists between the gate and source. These problems are exacerbated in the normally OFF type of MESFET in which the pinch-off voltage tends to zero.

To overcome these problems it has been proposed to etch a part of the active layer to produce a shallower region and then form the gate electrode on this shallower region. However it is difficult to produce repeatable and consistent devices by this technique.

According to a first aspect of this invention in a Schottky gate field effect transistor the active layer is divided in the lateral direction into a first portion directly under the gate electrode and having a thickness selected to provide the required pinch-off voltage, and second portions located adjacent and on opposite sides of the first portion; the second portions of the active layer being doped with a larger quantity of impurity per unit area than the first portion of the active layer; and, the interfaces between the first portion of the active layer and the adjacent sides of each of the second portions of the active layer being spaced from the Schottky gate electrode in the lateral direction substantially by the thickness of the first portion of the active layer.

According to a second aspect of this invention a method of producing a Schottky gate field effect transistor comprises the steps of: forming an active layer by implanting an impurity on the semi-insulating semiconductor substrate; forming a pattern on a first portion of the active layer; implanting an impurity using the pattern as a mask, to form other portions of the active layer on opposite sides of the portion of the active layer shielded by the pattern, the other portions of the active layer having a higher impurity dosage than the portion of the active layer shielded by the pattern, removing the pattern, and forming a gate electrode, a source electrode, and a drain electrode on top of the first portion and the other portions of the active layer, the interfaces between the other portions of the active layer and the first portion being spaced from the gate electrode by a distance substantially equal to the thickness of the portion of the active layer.

Such MESFETs have a large transconductance gm, satisfactory high frequency characteristics and are capable of ultra-high-speed logic operations. They can also be produced easily with a high yield.

Examples of a MESFET and a method of making it in accordance with this invention will now be described and contrasted with conventional devices in accordance with the accompanying drawings, in which:—

Figures 1 and 2 are cross-sections through conventional Schottky gate field effect transistors;

Figure 3 is a cross-section through an example of a Schottky gate field effect transistor accordung to the present invention; and,

Figures 4A, 4B and 4C are cross-sections illustrating the production steps of a Schottky gate field effect transistor according to the present invention.

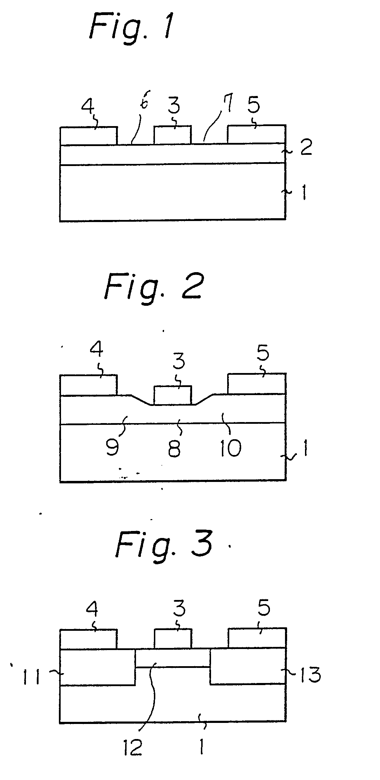

A most commonly used MESFET has the construction, as shown in Figure 1, comprising a high resistivity or semi-insulating semiconductor crystal substrate 1, a conductive semiconductor crystal layer commonly called an active layer 2, a Schottky electrode 3, and a source electrode 4 and a drain electrode 5 having ohmic characteristics, respectively.

Carrier density Nd and thickness $a$ of the active layer 2 has a relationship defined by the following equation (1) with pinch-off voltage Vp of the MESFET:

$$Vp = Vb - \frac{q\,Nd}{2\varepsilon}a^2 \qquad (1)$$

wherein, Vb denotes built-in voltage, $\varepsilon$ denotes dielectric constant of the semiconductor crystal, and q denotes quantum of the electric charge.

The value of Vp is given by the requirements in the circuit design, and the values of Nd and $a$ are determined by the equation (1) so as to satisfy the value Vp.

Conventional MESFET's of the construction shown in Figure 1 have disadvantages that a sufficiently large transconductance gm is not obtained because the resistance between the gate 3 and the source 4 or the gate 3 and the drain 5 is large and that the noise characteristic is lowered by the large serial resistance between the gate and the source. Particularly, when the absolute value of the pinch-off voltage Vp is small or in normally-off (Vp>0), the gate-source serial resistance becomes larger because the carrier density Nd or the thickness $a$ of the active layer 2 must be small as evident from the equation (1). When GaAs crystal is used as the active layer 2, a surface state of high density exists in each of crystal surfaces 6 and 7 between the gate and the source and between the gate and the drain, respectively, whereby a surface potential is made substantially constant and a depletion layer is formed in the neighbourhood of the surface within the semiconductor crystal, resulting in that the gate-source series resistance becomes larger. This was a very serious problem particularly in a normally-off type.

To overcome the foregoing disadvantages and problems, it was heretofore practiced to make, as shown in Figure 2, active layers 9 and 10 between the gate and the source and between the gate and the drain, respectively, thicker than an active layer 8 directly under the gate electrode. Devices made in this manner are shown in Figure 13 of the paper by Yokoyama et al at pages 1541—1547 of IEEE Transactions on Electron Devices, Vol. ED-29 No. 10. In this conventional practice, while the thickness of the active layer 8 and the carrier density must be determined to satisfy the conditions defined by the equation (1), it is difficult in the current technique as by etching to accurately and repeatably control the thickness of the active layer 8 in such a partially sloped construction.

An example of the MESFET according to the present invention shown in Fig. 3 comprises a highly resistive or semi-insulating semiconductor crystal substrate 1, an active layer 12 mounted on said substrate 1 under a Schottky gate electrode 3, an active layer 11 mounted on said substrate 1 extending from under an ohmic source electrode 4 to between the gate electrode 3 and the source electrode 4 and having a larger number of carriers per unit area than that of the active layer 12, and an active layer 13 extending from under an ohmic drain electrode 5 to between the gate electrode 3 and the drain electrode 5 and having a larger number of carriers per unit area than that of the active layer 12. Particularly, between each of the active layers 11, 13 and the gate electrode 3, there is provided a distance approximately identical to the thickness of the active layer 12.

In this way, by forming the active layer 11 extending from under the source electrode 4 to between the source and the gate electrodes 4 and 3 and the active layer 13 extending from under the drain electrode 5 to between the drain and the gate electrodes 5 and 3, the resistance between the source and the gate and the resistance between the drain and the gate can be reduced, thereby increasing the transconductance gm. For this purpose, it is preferred to dispose the active layers 11 and 13 as close as possible to the Schottky gate electrode 3.

On the other hand, however, when the aactive layers 11 and 13 are disposed very close to the Schottky gate electrode 3, the capacity between the gate and the source and the capacity between the gate and the drain are rapidly increased to thereby worsen the high frequency characteristics or the ultra-high-speed operation of the MESFET. In order to reduce the capacity, it is required that the active layers 11 and 13 are positioned sufficiently far from the Schottky gate electrode 3.

In the present invention, in order to satisfy the two above-mentioned conditions, the distance between each of the active layers 11 and 13 and the Schottky gate electrode 3 is determined optimally. This is disclosed in the "Japanese Journal of Applied Physics", Supplement Vol. 22 (1983) supl. 22-1, page 382—4.

Attention must first be paid to that depletion layers under the gate electrode 3 lie toward the active layers 11 and 13, respectively, from the ends of the Schottky gate electrode 3 by approximately the thickness of the active layer 12, in the active state of the MESFET in which the active layers 11 and 13 are positioned sufficiently far from the gate electrode 3 for the purpose of reducing the capacity between the gate and the source and the capacity between the gate and the drain. In this way, by providing a distance substantially equal to or greater than the thickness of the active layer 12 between each of the active layers 11 and 13 and the Schottky gate electrode 3, the rapid increase in the capacity between the gate and the source and the capacity between the gate and the drain can be prevented.

In the case where the distance between each of the active layers 11 and 13 and the Schottky gate electrode 3 is approximately equal to the thickness of the active layer 12, the effect to improve the transconductance gm obtained by a further decrease in this distance is very small because the resistance in the channel directly under the Schottky gate electrode 3 is sufficiently large when compared with those between the gate and the source and between the gate and the drain.

Accordingly, the optimal distance between each of the active layers 11 and 13 and the Schottky gate electrode 3 is substantially equal to the thickness of the active layer 12.

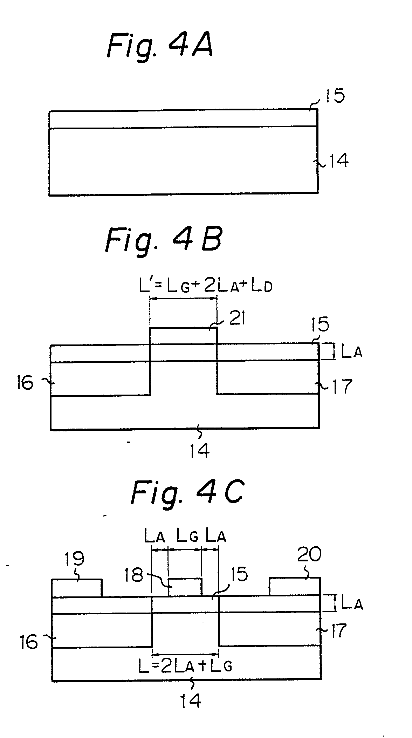

With reference now to Figs. 4A, 4B and 4C, an example of the method for producing MESFET according to the present invention will be described.

While the present invention is widely applicable to any of semiconductor materials, for example, elements such as Si and compounds, the method according to the present invention will be described with respect particularly to an example of GaAs as a semiconductor material from among various compounds for semiconductor having an advantage of high operation speed.

First, an active layer 15 is formed on a semi-insulating substrate 14 of GaAs as shown in Fig. 4A by ion implantation. The pinch-off voltage of MESFET is determined substantially by the active layer 15 thus formed. To produce a normally-off MESFET aiming at the pinch-off voltage+0.05 V, conditions of Si ion, implantation energy 50 KeV, and implantation quantity $2.1 \times 10^{12}$ dosage/$cm^2$ are selected.

Then, a pattern 21 of any suitable material is formed as shown in Fig. 4B. Thereafter, ion implantation is performed using the pattern as a mask to form a region 16 under a source electrode to be and intermediate between gate and source electrodes to be (not formed yet at this stage) and a region 17 under a drain electrode to be and intermediate between gate and drain electrodes to be (not formed yet at this stage).

Here, in order to reduce the resistance between the gate and the source and the resistance between the gate and the drain, it is required to make as high as possible the number of carriers per unit area in the regions 16 and 17, that is the sheet carrier. In order to satisfy this requirement and to keep the number of carriers per unit area within the limits of GaAs, it is effective to select, in the ion implantation of the active layers of the regions 16 and 17, the acceleration energy to at least larger than 100 KeV and the dosage to at least larger than twice of the ion implantation used for the active layer 15. In the example, the conditions of Si ion, implantation energy 180 KeV and implanting quantity $1 \times 10^{13}$ dosage/cm² are selected.

At this time, the distance between the regions 16 and 17 in the mask pattern 21 is determined to provide the distance between each of the regions 16 and 17 and the Schottky gate electrode 18 in the processed MESFET substantially equal to the thickness of the active layer 15.

In order to accomplish this object, the distance L' between the regions 16 and 17 at the stage where the mask pattern 21 is formed, that is the widthwise length of the mask pattern 21, is, as shown in Fig. 4B, determined by the following equation (2):

$$L'=L_G+2L_A+2L_D \qquad (2)$$

where,
$L_G$: gate length of MESFET
$L_A$: thickness of region 15
$L_D$: sum of widthwise scattering length by ion plantation and widthwise thermal diffusion by annealing process.

In this example, $L_A$ is 0.1 µm, $L_D$ is selected to a suitable value from 0.1 µm to 0.4 µm according to the processing conditions. In this example, $L_D$ is selected to 0.1 µm in consideration of the subsequent annealing process.

A resist pattern formed by common photolithography is used most widely as the mask pattern 21. In the example, the pattern is formed of positive photo resist (AZ-1350J) of 1.5 µm thickness. After removal of the resist, annealing is performed at 800°C for about 20 minutes to activate the implanted element. At this occasion, in the case where GaAs is used as the crystal substrate, the surface is protected as by proximity method.

In Fig. 4B, after completion of the ion implantation to the active layer in the regions 16 and 17 and the subsequent annealing process, the distance L between the regions 16 and 17 is decreased by the length $2L_D$ by the widthwise scattering due to the ion implantation and the widthwise thermal diffusion due to the annealing process. As the result, the final distance L between the regions 16 and 17 is defined by the following equation as shown in Fig. 4C:

$$L=L_G+2L_A \qquad (3)$$

Thereafter, the gate electrode 18, the source electrode 19, and the drain electrode 20 are formed by usual method as shown in Fig. 4C.

In the Schottky gate field effect transistor according to the present invention, since the capacity between the gate and the source and the capacity between the gate and the drain are small and since the resistance between the gate and the source and the resistance between the gate and the drain are small, a large transconductance gm is obtained, thereby accomplishing ultra-high-frequency operation, ultra-high-speed operation, and low noise characteristics.

The MESFET according to the present invention is most suitable as an ultra-high-speed logical device. Further, the production method according to the present invention provides a valuable industrial applicability because it makes it possible to produce the MESFET's very easily and at a high yield.

**Claims**

1. A Schottky gate field effect transistor comprising a semi-insulating semiconductor substrate (1), an active layer (11, 12, 13) formed on the semiconductor substrate (1), and a source electrode (4), a Schottky gate electrode (3), and a drain electrode (5) all formed on the active layer (11, 12, 13),
the active layer being divided in the lateral direction into a first portion (12) directly under the gate electrode (3) and having a thickness selected to provide the required pinch-off voltage, and second portions (11, 13) located adjacent and on opposite sides of the first portion (12); and
the second portions (11, 13) of the active layer being doped with a larger quantity of impurity per unit area than the first portion (12) of the active layer;
characterised in that:
the interfaces between the first portion (12) of the active layer and the adjacent sides of each of the second portions (11, 13) of the active layer are spaced from the Schottky gate electrode (3) in the lateral direction substantially by the thickness of the first portion (12) of the active layer.

2. A method of producing a Schottky gate field effect transistor, comprising the steps of:
forming an active layer (15) by implanting an impurity on a semi-insulating semiconductor substrate (14);
forming a pattern (21) on a first portion of the active layer (15);
implanting an impurity using the pattern (21) as a mask, to form other portions (16, 17) of the active layer on opposite sides of the portion of the active layer (15) shielded by the pattern (21), the other portions (16, 17) of the active layer having a higher impurity dosage than the portion (15) of the active layer shielded by the pattern (21);
removing the pattern (21); and,
forming a gate electrode (18), a source electrode (19), and a drain electrode (20) on top of the first portion (15) and the other portions (16, 17) of the active layer, the interfaces between the other portions (16, 17) of the active layer and the first portion being spaced from the gate electrode (18) by a distance substantially equal to the thickness of the first portion (15) of the active layer.

3. A method of producing a Schottky gate field effect transistor according to claim 2, in which the implantation of the impurity using the pattern (21) as the mask to form the other portions (16, 17) of the active layer is performed with the accelerating energy of at least 100 KeV and a dosage at least twice that used to implant the portion (15) of the active layer.

4. A method for producing a Schottky gate field effect transistor according to claims 2 or 3, in which the pattern (21) is a resist pattern formed by photo-lithography.

**Patentansprüche**

1. Schottky-Feldeffekttransistor mit einem halbisolierenden Halbleitersubstrat (1), einer auf dem Halbleitersubstrat (1) ausgebildeten aktiven Schicht (11, 12, 13) und einer Source-Elektrode (4), einer Schottky-Gate-Elektrode (3) und einer Drain-Elektrode (5), die alle auf der aktiven Schicht (11, 12, 13) ausgebildet sind,

wobei die aktive Shicht in seitlicher Richtung in ein erstes Teil (12), das direkt unter der Gate-Elektrode (3) angeordnet ist und eine die erforderliche Abschnürspannung vorsehende Dicke aufweist, und zweite Teile (11, 13) unterteilt ist, die benachbart und an gegenüberliegenden Seiten des ersten Teils (12) angeordnet sind; und

wobei die zweiten Teile (11, 13) der aktiven Schicht mit einer größeren Störstellenmenge pro Einheitsfläche als das erste Teil (12) der aktiven Schicht dotiert sind;

dadurch gekennzeichnet, daß

die Grenzflächen zwischen dem ersten Teil (12) der aktiven Schicht und den benachbarten Seiten jedes der zweiten Teile (11, 13) der aktiven Schicht von der Schottky-Gate-Elektrode (3) im wesentlichen um die Dicke des ersten Teils (12) der aktiven Schicht in seitlicher Richtung versetzt sind.

2. Verfahren zur Herstellung eines Schottky-Feldeffekttransistors, das die Schritte aufweist:

Ausbilden einer aktiven Schicht (15) durch Implantieren einer Störstelle auf ein halbisolierendes Halbleitersubstrat (14);

Ausbilden eines Musters (21) auf einem ersten Teil der aktiven Schicht (15);

Implantieren einer Störstelle unter Verwendung des Musters (21) als Maske zur Ausbildung anderer Teile (16, 17) der aktiven Schicht an gegenüberliegenden Seiten des Teils der aktiven Schicht (15), das durch das Muster (21) abgeschirmt ist, wobei die anderen Teile (16, 17) der aktiven Schicht eine höhere Störstellendosierung als das Teil (15) der aktiven Schicht aufweist, das durch das Muster (21) abgeschirmt ist;

Entfernen des Musters (21); und

Ausbilden einer Gate-Elektrode (18), einer Source-Elektrode (19) und einer Train-Elektrode (20) auf der Oberseite des ersten Teils (15) und der anderen Teile (16, 17) der aktiven Schicht, wobei die Grenzflächen zwischen den anderen Teilen (16, 17) der aktiven Schicht und dem ersten Teil von der Gate-Elektrode (18) um einen Abstand abgesetzt sind, der im wesentlichen der Dicke des ersten Teils (15) der aktiven Schicht entspricht.

3. Vefahren zur Herstellung eines Schottky-Feldeffekttransistors nach Anspruch 2, bei dem die Implantation der Störstelle unter Verwendung des Musters (21) als Maske zur Ausbildung der anderen Teile (16, 17) der aktiven Schicht mit einer Beschleunigungsenergie von wenigstens 100 keV und einer Dosierung durchgeführt wird, die wenigstens dem Doppelten der Dosierung entspricht, die bei der Implantierung des ersten Teils (15) der aktiven Schicht Verwendung findet.

4. Verfahren zur Herstellung eines Schottky-Feldeffekttransistors nach den Ansprüchen 2 oder 3, bei dem das Muster (21) ein durch Fotolitographie ausgebildetes Abdeckmuster ist.

**Revendications**

1. Transistor à effet de champ Schottky comprenant un substrat semiconducteur semi-isolant (1), une couche active (11, 12, 13) formée sur le substrat semiconducteur (1) et une électrode de source (4), une électrode de porte de Schottky (3) et une électrode de drain (5), toutes formées sur la couche active (11, 12, 13),

la couche active étant divisée en direction latérale en une première portion (12) directement sous l'électrode de porte (3) et ayant une épaisseur choisie pour produire la tension requise de pincement et des secondes portions (11, 13) placées adjacentes à et sur des côtés opposés de la première portion (12); et

les secondes portions (11, 13) de la couche active étant dopées d'une plus grande quantité d'impureté par unité de surface que la première portion (12) de la couche active;

caractérisé en ce que

les interfaces entre la première portion (12) de la couche active et les côtés adjacents de chacune des secondes portions (11, 13) de la couche active sont espacées de l'électrode de porte de Schottky (3) en direction latérale, sensiblement par l'épaisseur de la première portion (12) de la couche active.

2. Procédé de fabrication d'un transistor à effet de champ Schottky comprenant les étapes de:

former une couche active (15) par implantation d'une impureté sur un substrat semiconducteur semi-isolant (14);

former un schéma (21) sur une première portion de la couche active (15);

implanter une impureté en utilisant le schéma (21) comme masque, pour former d'autres portions (16, 17) de la couche active sur des côtés opposés de la portion de la couche active (15) protégée par le schéma (21), les autres portions (16, 17) de la couche active ayant une dose plus importante d'impureté que la portion (15) de la couche active protégée par le schéma (21);

enlever le schéma (21); et

former une électrode de porte (18), une électrode de source (19) et une électrode de drain (20) au-dessus de la première portion (15) et des autres portions (16, 17) de la couche active, l'interface entre les autres portions (16, 17) de la couche active et la première portion étant espacée de l'électrode de porte (18) par une distance sensiblement égale à l'épaisseur de la première portion (15) de la couche active.

3. Procédé de fabrication d'un transistor à effet de champ Schottky selon la revendication 2, où l'implantation de l'impureté en utilisant le schéma (21) comme masque pour former les autres portions (16, 17) de la couche active est accomplie à une énergie d'accélération d'au moins 100 keV et à une dose qui est au moins le double de celle utilisée pour implanter la portion (15) de la couche active.

4. Procédé de fabrication d'un transistor à effet de champ Schottky selon la revendication 2 ou 3 où le schéma (21) est un schéma photosensible formé par photolithographie.

*Fig. 1*

*Fig. 2*

*Fig. 3*

## Fig. 4A

## Fig. 4 B

$$L' = L_G + 2L_A + L_D$$

## Fig. 4 C

$$L_A \quad L_G \quad L_A$$

$$L = 2L_A + L_G$$

2